(19) Europäisches Patentamt
European Patent Office
Office européen des brevets

(11) **EP 4 117 182 B1**

(12) **EUROPEAN PATENT SPECIFICATION**

(45) Date of publication and mention
of the grant of the patent:
**18.12.2024 Bulletin 2024/51**

(21) Application number: **22183327.0**

(22) Date of filing: **06.07.2022**

(51) International Patent Classification (IPC):
$H03K\ 17/16^{(2006.01)}$  $H03K\ 17/082^{(2006.01)}$
$H03K\ 17/284^{(2006.01)}$  $H02M\ 1/08^{(2006.01)}$
$H03K\ 17/14^{(2006.01)}$  $H02M\ 1/32^{(2007.01)}$
$H02M\ 7/5387^{(2007.01)}$

(52) Cooperative Patent Classification (CPC):
**H03K 17/165; H02M 1/0029; H02M 1/0054;
H02M 1/08; H03K 17/0822; H03K 17/145;
H03K 17/284; H02M 1/32; H02M 1/327;
H02M 7/5387; H03K 2217/0027; Y02B 70/10**

(54) **GATE DRIVE CIRCUIT AND POWER CONVERTER**

GATE-TREIBERSCHALTUNG UND LEISTUNGSWANDLER

CIRCUIT DE COMMANDE DE GRILLE ET CONVERTISSEUR DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.07.2021 JP 2021113061**

(43) Date of publication of application:
**11.01.2023 Bulletin 2023/02**

(73) Proprietor: **Toshiba Infrastructure Systems &
Solutions Corporation
Kawasaki-shi, Kanagawa 212-0013 (JP)**

(72) Inventors:
• **Takimoto, Kazuyasu
Kawasaki-shi, Kanagawa, 212-0013 (JP)**
• **Kuzumaki, Atsuhiko
Kawasaki-shi, Kanagawa, 212-0013 (JP)**
• **Matsushita, Akihisa
Kawasaki-shi, Kanagawa, 212-0013 (JP)**
• **Mochikawa, Hiroshi
Kawasaki-shi, Kanagawa, 212-0013 (JP)**

(74) Representative: **Hoffmann Eitle
Patent- und Rechtsanwälte PartmbB
Arabellastraße 30
81925 München (DE)**

(56) References cited:
**US-A1- 2017 093 392    US-A1- 2017 104 479
US-A1- 2021 184 557    US-B1- 10 505 529**

**Description**

FIELD

Embodiments described herein relate generally to a gate drive circuit and a power converter.

BACKGROUND

A power converter includes power switching devices such as IGBTs (Insulated Gate Bipolar Transistors) or MOSFETs (Metal-Oxide-Semiconductor Field-Effect Transistors), and the power switching devices are switched to achieve desired power conversion.

When a power switching device is being turned off, a surge voltage is generated, and a turn-off loss occurs. For example, when a surge voltage generated in a power switching device exceeds a withstand voltage of the power switching device, the power switching device is destroyed; and accordingly, the power converter malfunctions. On the other hand, when a turn-off loss increases, temperature of the power switching device increases. As a result, when the temperature of the power switching device exceeds a temperature tolerance, the power switching device is destroyed; and accordingly, the power converter malfunctions.

Generally, there is a trade-off relationship between the surge voltage and the turn-off loss as to the power switching device. For example, slowing a turning off speed of the power switching device results in a reduction in surge voltage and an increase in turn-off loss.

To date, there has been a proposal, by using a power switching device to which a new material such as SiC (silicon carbide) is applied, to increase a switching speed of the power switching device and to reduce the turn-off loss in the power switching device. There has also been a proposal, by devising a way of driving the power switching device, to reduce the turn-off loss.

For example, in the case of a power converter including a power switching device with a new material such as SiC, there has been a risk of inability to suppress a surge voltage because switching of gate driving speed cannot catch up with switching operation of the power switching device in consideration of factors such as delays in components.

US 2017/0093392 A1 relates to a method and a circuit for adjusting a timing of changing a turning-off speed midway when a drive circuit turns off a voltage-driven semiconductor element.

US 2017/104479 A1 relates to a drive device that performs an on/off operation of a power switching element taking into consideration temperature characteristics.

US 2021/184557 A1 relates to a drive device for a switch, the drive device performing switching of switches configuring an electrical power converter.

US 10 505 529 B1 relates to a switching device, a power converter device, a control apparatus, and a computer program product.

The present invention is defined by the independent claims. Preferred embodiments are defined by the dependent claims. Further examples are provided for facilitating the understanding of the invention.

BRIEF DESCRIPTION OF THE DRAWINGS

FIG. 1 schematically illustrates an example configuration of a power converter of a first embodiment;
FIG. 2 schematically illustrates an example configuration of a gate drive circuit of the first embodiment;
FIG. 3 schematically illustrates a relationship between a resistance value and a surge voltage in an off-mode slow drive circuit and an off-mode fast drive circuit illustrated in FIG. 2;
FIG. 4 is a timing chart for describing an example of operation of the gate drive circuit when the switching device is being turned off in the first embodiment;
FIG. 5 schematically illustrates an example configuration of a gate drive circuit of a second embodiment;
FIG. 6 is a chart for describing an example of change in characteristics of the switching device depending on an operating condition of the power converter;
FIG. 7 is a chart for describing another example of change in characteristics of switching device depending on the operating condition of the power converter;
FIG. 8 is a chart for describing another example of change in characteristics of switching device depending on the operating condition of the power converter;
FIG. 9 schematically illustrates an example configuration of a gate drive circuit of a third embodiment;
FIG. 10 is a chart for describing an example of operation of switching between operating states of a first off-mode fast drive circuit and a second off-mode fast drive circuit by a delay circuit in a third embodiment;

FIG. 11 is a timing chart for describing an example of operation of the gate drive circuit when the switching device is being turned off in the third embodiment;

FIG. 12 schematically illustrates an example configuration of a gate drive circuit of a fourth embodiment;

FIG. 13 is a chart for describing an example of operation of switching between operating states of first off-mode slow drive circuit and second off-mode slow drive circuit by a switching circuit in the fourth embodiment;

FIG. 14 is a timing chart for describing an example of operation of the gate drive circuit when the switching device is being turned off in the fourth embodiment;

FIG. 15 schematically illustrates an example configuration of a gate drive circuit of a fifth embodiment;

FIG. 16 is a timing chart for describing an example of operation of the gate drive circuit when the switching device is being turned on in the fifth embodiment;

FIG. 17 schematically illustrates an example configuration of a gate drive circuit of a sixth embodiment; and

FIG. 18 is a timing chart for describing an example of operation of the gate drive circuit when the switching device is being turned on in the sixth embodiment.

## DETAILED DESCRIPTION

A gate driver circuit according to an embodiment includes: a first voltage detector that detects a first voltage between a first terminal and a second terminal of a switching device and outputs voltage information based on the detected first voltage; a delay circuit that outputs, with a delay for a predetermined time, the voltage information from the voltage detector; a first off-mode drive circuit that applies a control signal to a control terminal of the switching device for turning off the switching device; and a second off-mode drive circuit that applies a control signal to the control terminal of the switching device for turning off the switching device. The first off-mode drive circuit turns off the switching device faster than the second off-driving circuit, and stops its operation for turning off the switching device when the voltage information indicates that the first voltage exceeds a predetermined threshold value.

A gate drive circuit and a power converter of embodiments will now be described in detail with reference to the drawings.

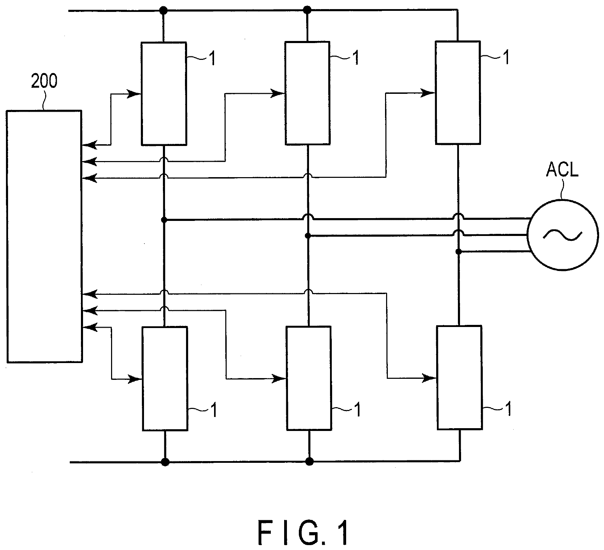

FIG. 1 schematically illustrates an example configuration of a power converter of a first embodiment.

A power converter of the embodiment comprises a plurality of switching devices 1 and a drive circuit 200. For example, the power converter is connected between a DC power supply (or DC load), which is not illustrated, and an AC load (or AC power supply) ACL.

The power converter is, for example, a three-phase AC power converter that comprises U-phase, V-phase, and W-phase legs. Each phase leg is connected between a high-potential side DC link and a low-potential side DC link. Each phase leg includes an upper arm and a lower arm, and is electrically connected to an AC load (or AC power supply) ACL between the upper arm and the lower arm (AC end).

Each of the upper arm and the lower arm comprises at least one switching device 1. The switching device 1 is a power switching device such as an IGBT or a MOSFET, and is controlled to operate by a control signal supplied from the drive circuit 200.

The drive circuit 200 controls operation of the switching device 1 based on a gate signal (upper-level control signal) supplied from an upper-level (an external) controller and information obtained from a plurality of switching devices 1.

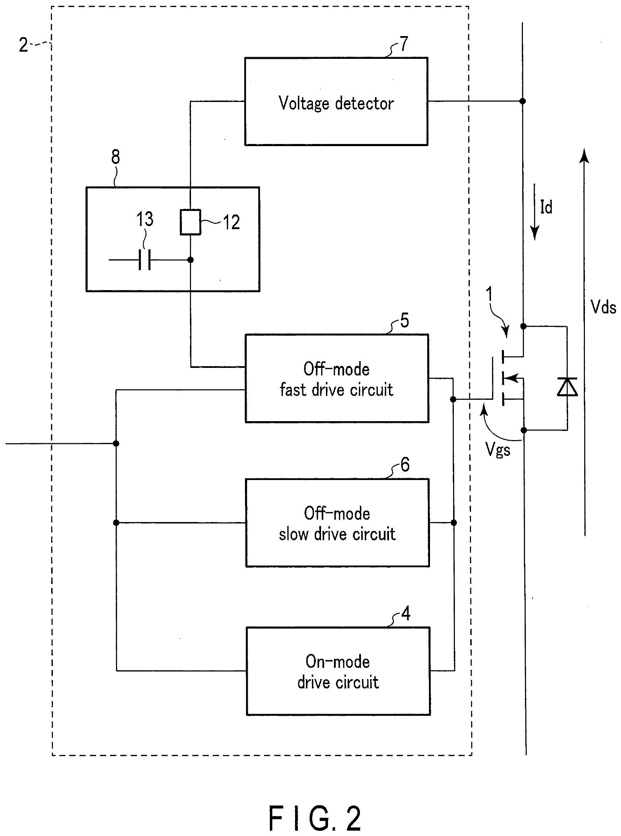

FIG. 2 schematically illustrates an example configuration of a gate drive circuit of the first embodiment.

The drive circuit 200 comprises a plurality of gate drive circuits 2 that control operation of a plurality of switching devices 1. FIG. 2 schematically illustrates an example configuration of a gate drive circuit 2 that controls a switching device 1.

The switching device 1 is, for example, a MOSFET. The switching device 1 comprises a gate terminal (control terminal), a source terminal (first terminal), and a drain terminal (second terminal). The source terminal of the switching device 1 of the upper arm is electrically connected to the AC terminal, and the drain terminal is electrically connected to the high-potential side DC link. The source terminal of the switching device 1 of the lower arm is electrically connected to the low-potential side DC link and the drain terminal is electrically connected to the AC terminal. The gate terminal of the switching device 1 is electrically connected to an output terminal of the gate drive circuit 2. The switching device 1 is switched by a gate voltage applied to the gate terminal between a state in which electrical connection is made between the source terminal and the drain terminal ("on" state) and a state of being cut off ("off" state).

The switching devices 1 may be any other power switching devices. For example, in the case in which an IGBT is applied as the switching device 1, the switching device 1 comprises a gate terminal (control terminal), an emitter terminal (first terminal), and a collector terminal (second terminal), and electrical connection states ("on" or "off") between the emitter terminal and the collector terminal are controlled by a gate voltage (control signal) applied to the gate terminal.

The gate drive circuit 2 comprises an on-mode drive circuit 4, an off-mode fast drive circuit (first off-mode drive circuit) 5, an off-mode slow drive circuit (second off-mode drive circuit) 6, a voltage detector 7, and a delay circuit 8.

The on-mode drive circuit 4 comprises an on-mode resistor (not illustrated) electrically connected to the gate terminal of the switching device 1. The gate signal is input to the on-mode drive circuit 4 from the upper-level controller. The on-mode drive circuit 4 is configured to operate, for example, for the duration in which the gate signal is "on" and applies a control signal (gate voltage) for turning on the switching device 1 through the on-mode resistor to the gate terminal.

The voltage detector 7 detects a value of a drain-source voltage (inter-terminal voltage) Vds of the switching device 1 and supplies the detected value to the delay circuit 8. The voltage detector 7 may output any value corresponding to the drain-source voltage Vds. Furthermore, the voltage detector 7 may compare the value of the drain-source voltage with a predetermined threshold and, result of the comparison, supply a truth value (voltage information) to the delay circuit 8, in place of the supply of the detected value of the drain-source voltage.

The delay circuit 8 supplies, with a delay for a predetermined time, a voltage value (or voltage equivalent value) supplied from the voltage detector 7 to the off-mode fast drive circuit 5. The delay circuit 8 is composed of a resistor 12 and a capacitor 13, and delays an input value by an amount equal to time constant corresponding to a product of a capacitance Cd of the capacitor 13 and a resistance value Rd of the resistor 12. Accordingly, time required for delaying the input value can be adjusted by selecting values of the capacitance Cd and the resistance value Rd. In the embodiment, the value of a delayed drain-source voltage Vds output from the delay circuit 8 represents a signal for switching between operating states (operating or stopped) of the off-mode fast drive circuit 5. On the other hand, if the truth value is supplied from the voltage detector 7, the delay circuit 8 supplies, with the delay for the predetermined time, the truth value to the off-mode fast drive circuit 5.

The off-mode fast drive circuit 5 includes a first off-mode resistor (not illustrated) electrically connected to the gate terminal of the switching device 1. To the off-mode fast drive circuit 5, the gate signal is input from the upper-level controller and the value of a delayed drain-source voltage Vds output from the delay circuit 8 is input. The off-mode fast drive circuit 5 is configured to apply a control signal (gate voltage) for turning off the switching device 1 through the first off-state resistor to the gate terminal, for example, for the duration in which the gate signal is off.

The off-mode fast drive circuit 5 is configured to stop operation of applying the control signal to the gate terminal when the value of the delayed drain-source voltage Vds is equal to or above a predetermined threshold value (for example, when the delayed drain-source voltage Vds rises).

On the other hand, in the case that the truth value is supplied to the off-mode fast drive circuit 5 from the delay circuit 8, the off-mode fast drive circuit 5, based on the supplied truth value, stops the supply of the control signal to the gate terminal.

In other words, for the duration after the gate signal is turned off and until the delayed drain-source voltage Vds rises, off-mode fast drive circuit 5 applies a control signal for turning off the switching device 1 through the first off-mode resistor to the gate terminal.

The off-mode slow drive circuit 6 includes a second off-mode resistor (not illustrated) electrically connected to the gate terminal of the switching device 1. The gate signal is input to the off-mode slow drive circuit 6 from the upper-level controller. The off-mode slow drive circuit 6 applies a control signal for turning off the switching device 1 through the second off-mode resistor to the gate terminal, for example, for the duration in which the gate signal is turned off. The resistance value of the second off-mode resistor is larger than the resistance value of the first off-mode resistor.

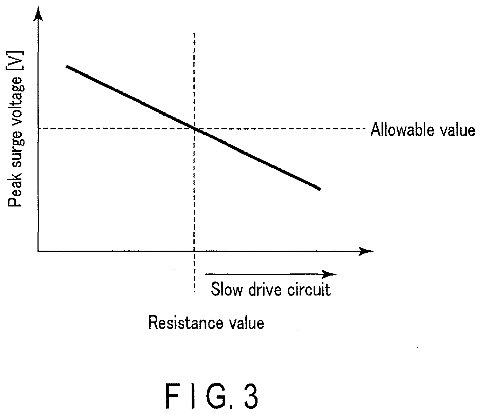

FIG. 3 schematically illustrates a relationship between a resistance value and a surge voltage in an off-mode slow drive circuit and an off-mode fast drive circuit illustrated in FIG. 2.

The resistance value of the second off-mode resistor of the off-mode slow drive circuit 6 is set such that, for example, the off-mode slow drive circuit 6 achieves turning-off as fast as a peak surge voltage generated in the switching device 1 can be kept below an allowable value. The resistance value of the first off-mode resistor of the off-mode fast drive circuit 5 is set such that, for example, the off-mode fast drive circuit 5 can turn off the switching device 1 faster than the off-mode slow drive circuit 6.

In this way, it is possible for the off-mode slow drive circuit 6 to operate such that the peak surge voltage in the switching device 1 can be suppressed below the allowable value, and for the off-mode fast drive circuit 5 to operate such that a turn-off loss in the switching device 1 is reduced.

An example of operation of the gate drive circuit 2 will now be described.

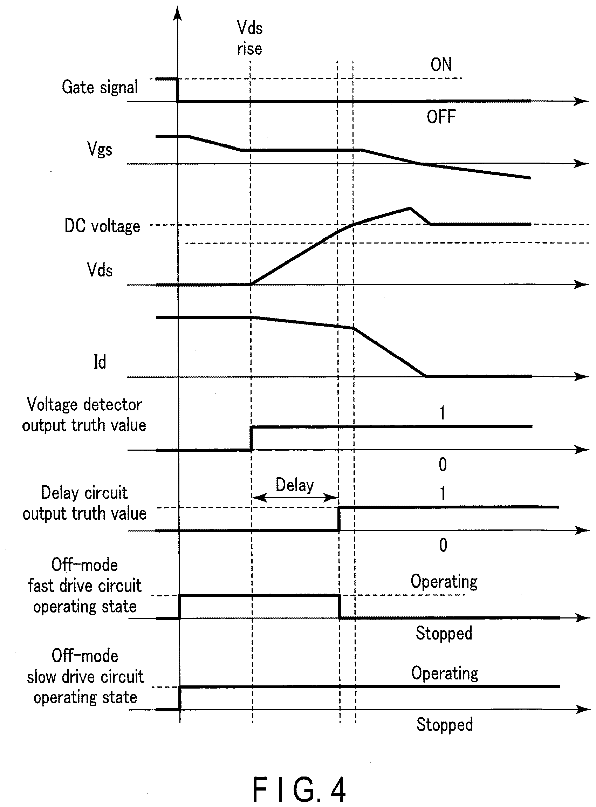

FIG. 4 is a timing chart for describing an example of operation of the gate drive circuit when the switching device is being turned off in the first embodiment.

Here, examples of the gate signal input to the gate drive circuit 2, the drain-source voltage Vds and a gate-source voltage Vgs of the switching device 1, a drain current Id, the truth value output from the voltage detector 7, a truth value output from the delay circuit 8, the operating state (operating or stopped) of the off-mode fast drive circuit 5, and the operating state (operating or stopped) of the off-mode slow drive circuit 6 are indicated in a timing chart.

The truth value output from the voltage detector 7 is, for example, "0" when the detected value of the voltage detector 7 is below a predetermined threshold value and "1" when the detected value is equal to or above the predetermined threshold value. In the embodiment, the value of the drain-source voltage Vds when the switching device 1 is being turned on is assumed to be the predetermined threshold value and the truth value is turned to "1" at a timing of a rise in the drain-source voltage Vds.

When the gate signal is switched from "on" to "off", the off-mode fast drive circuit 5 and the off-mode slow drive circuit 6 go into an operating state, and the gate-source voltage Vgs of the switching device 1 starts to decrease. Once the gate-source voltage Vgs of the switching device 1 decreases to a predetermined value, the drain-source voltage Vds rises and the drain current Id starts to decrease.

At a timing of a rise in the drain-source voltage Vds, the truth value output from the voltage detector 7 changes from "0" to "1", and a voltage value above a predetermined threshold value is input from the voltage detector 7 to the delay circuit 8.

The delay circuit 8 outputs, with a delay for a predetermined time, the value input from the voltage detector 7. Accordingly, the output truth value of the delay circuit 8 changes from "0" to "1" with a predetermined time delay from the timing of a rise in the truth value output from the voltage detector 7.

When the truth value output from the delay circuit 8 turning to "1", the off-mode fast drive circuit 5 is changed from the operating state to a stopped state. In other words, turning-off operation of the switching device 1 is controlled by the off-mode fast drive circuit 5 and the off-mode slow drive circuit 6 until a lapse of a predetermined delay time after the drain-source voltage Vds of the switching device 1 exceeds a predetermined threshold value. After a lapse of a predetermined delay time after the drain-source voltage Vds of the switching device 1 exceeds a predetermined threshold value, the turning-off operation of the switching device 1 is controlled only by the off-mode slow drive circuit 6.

According to the operation described above, at the initial stage of turning off, the switching device 1 is rapidly turned off by the off-mode fast drive circuit 5 and the off-mode slow drive circuit 6, so that the turn-off loss can be reduced. On the other hand, after the off-mode fast drive circuit 5 goes into the stop state, the switching device 1 is turned off only by the off-mode slow drive circuit 6, so that the surge voltage in the switching device 1 can be suppressed.

In the gate drive circuit of the embodiment, a rise in the drain-source voltage Vds is detected, and after a predetermined time starting from the timing of the rise being detected, the off-mode fast drive circuit 5 goes into the stop state. In this way, when the switching device 1, for example made with a material such as SiC, is being turned off, the off-mode fast drive circuit 5 can be stopped without delay during a high-speed operation to transition to a low-speed operation.

On the other hand, if the off-mode fast drive circuit 5 is stopped too early, a slow driving duration becomes longer within the duration in which the switching device 1 is turned off, and therefore turn-off loss may increase. It is possible to suppress the turn-off loss of the switching device 1 and the surge voltage by setting the delay time in the delay circuit 8 to an appropriate time to stop the off-mode fast drive circuit 5.

An exemplary way to set the delay time in the delay circuit 8 will be described. Here, as operational conditions of the power converter, a DC voltage (voltage between DC main circuits) is defined as Vcc [V] and a maximum value of a rate of voltage change is defined as dVdtMax [V/s].

In turning-off operation of a typical switching device, when the drain-source voltage Vds reaches a DC voltage value (a voltage value at the time of completion of turning off of the switching device), the drain current Id starts to drop significantly. The magnitude of the surge voltage has a value corresponding to a rate of change of the drain current Id at the time the drain current Id starts to drop. Accordingly, to properly suppress the surge voltage, it is preferable to set the off-mode fast drive circuit 5 to a stop state before the drain-source voltage Vds reaches the DC voltage Vcc. In the above, a time Tvcc required for the drain-source voltage Vds to reach the DC voltage Vcc can be calculated by the following expression (1).

$$Tvcc = Vcc/dVdtMax \qquad (1)$$

Further, in an actual power converter, each of components constituting the voltage detector 7, the delay circuit 8, and the off-mode fast drive circuit 5 has an inherent delay. Accordingly, considering a total amount of delays of components constituting the power converter (the sum total of delay time of the components) Tdevice, setting can be made such that delay time Td of the delay circuit 8 satisfies the following expression (2), so that the off-mode fast drive circuit 5 can be go into the stop state before the drain-source voltage Vds reaches the DC voltage Vcc, and therefore the surge voltage can be suppressed.

$$Td < Tvcc - Tdevice = Vcc/dVdtMax - Tdevice \qquad (2)$$

Further, a balance between the surge voltage suppression and the turn-off loss suppression in the switching device 1 can be adjusted by adjusting a delay amount in the delay circuit 8 within the range of the above-described relationship being satisfied.

As described above, in the gate drive circuit and the power converter of the embodiment, the gate driving speed is increased (driven at a low gate resistance value) at the start of turning-on of the switching device for achieving low loss, and on the other hand, a gate driving speed can be reduced (driven at a high gate resistance value) with an adjusted delay on condition that the beginning of a rise in voltage of the switching device is detected. In this way, it is possible to ensure that the surge voltage in the switching device can be reduced.

In other words, according to the embodiment, a gate drive circuit and a power converter that provide for suppression of a surge voltage in a switching device and a reduction in switching loss can be provided.

A gate drive circuit and a power converter of a second embodiment will now be described in detail with reference to the drawings. In the description below, like components as in the first embodiment will be given like reference characters and the description will not be repeated.

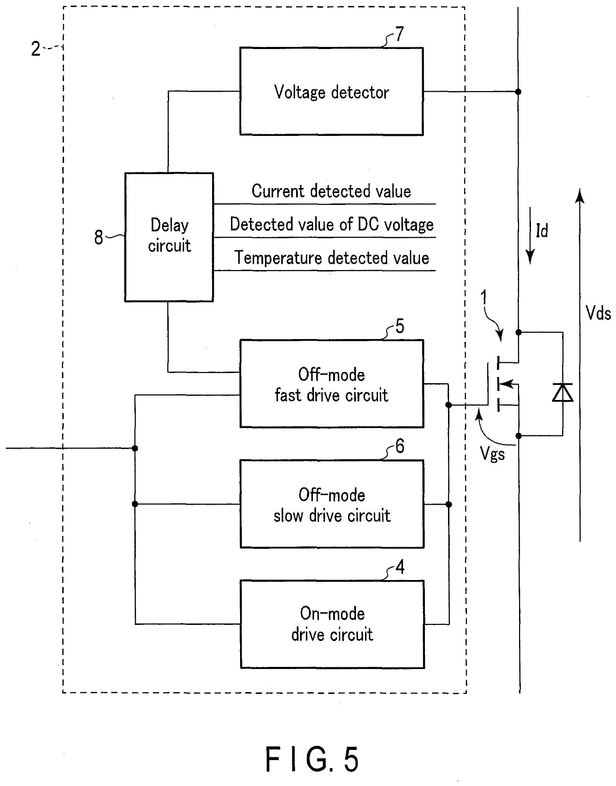

FIG. 5 schematically illustrates an example configuration of a gate drive circuit of a second embodiment.

A gate drive circuit 2 and a power converter of the embodiment are different from those of the first embodiment in that various detectors (not illustrated) for detecting operating condition of the power converter are provided and the delay circuit 8 is differently configured.

In the embodiment, values of operating condition of the power converter detected by the detectors (for example, a current detected value, a detected value of DC voltage, a temperature detected value, and the like) are input to the delay circuit 8. The delay circuit 8 is configured to adjust delay time of an output signal with respect to an input signal depending on the operating condition of the power converter.

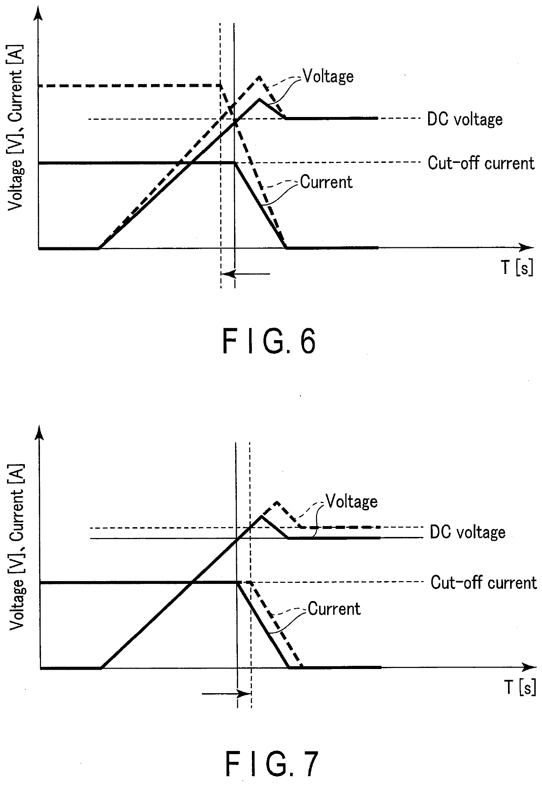

FIG. 6 is a chart for describing an example of change in characteristics of the switching device depending on operating condition of the power converter. In FIG. 6, a drain-source voltage Vds and a drain current Id when a cut-off current (the drain current Id at the start of turning-off operation) is relatively large are indicated by dashed lines, and the drain-source voltage Vds and the drain current Id when the cut-off current is relatively small are indicated by solid lines.

Here, a voltage change rate increases as the cut-off current of the switching device 1 increases. Accordingly, when the cut-off current increases, time from when the drain-source voltage Vds rises to when it reaches DC voltage Vcc is shortened when the switching device 1 is being turned off. Accordingly, the delay circuit 8 may be configured to shorten the delay time as the value of the cut-off current (the current detected value of the drain current Id at the start of turning-off operation) is larger.

FIG. 7 shows another example of change in properties of switching device depending on the operating condition of the power converter. In FIG. 7, a drain-source voltage Vds and a drain current Id when a DC voltage Vcc of the power converter is relatively large are indicated by dashed lines, and the drain-source voltage Vds and the drain current Id when the DC voltage Vcc of the power converter is relatively small are indicated by solid lines.

Here, time for the drain-source voltage Vds to reach the DC voltage Vcc is longer as the DC voltage Vcc is larger. Accordingly, the delay circuit 8 may be configured to increase the delay time as the DC voltage Vcc is larger.

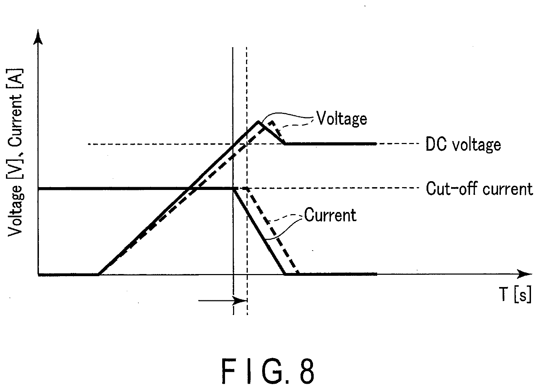

FIG. 8 is a chart showing another example of change in properties of switching device depending on the operating condition of the power converter. In FIG. 8, the drain-source voltage Vds and the drain current Id when temperature of the switching device 1 is relatively high is indicated by dashed lines, and the drain-source voltage Vds and the drain current Id when the temperature of the switching device 1 is relatively low is indicated by solid lines.

Here, time for the drain-source voltage Vds to reach the DC voltage Vcc becomes longer as the temperature of the switching device 1 is higher. Accordingly, the delay circuit 8 may be configured to increase the delay time as the temperature detected value of the switching device 1 is larger.

A plurality of delay time and threshold values for switching the plurality of delay time, for example, may be stored in the delay circuit 8 in advance for at least one of values indicative of the operating condition of the power converter (a value of the cut-off current, a value of the DC voltage Vcc, a temperature value of the switching device 1). The delay circuit 8 can obtain at least one of detected values of the cut-off current, the DC voltage Vcc, and the temperature of the switching device 1 as the operating condition of the power converter before turning-off operation is started, and switch the current delay time to other delay time in the plurality of delay time depending on whether or not the detected value is equal to or above the threshold value.

The delay circuit 8 may adjust the delay time by adding or subtracting predetermined time to or from the current delay time depending on whether or not the value indicative of the operating condition of the power converter is equal to or above the predetermined threshold value.

As described above, according to the embodiment, the delay circuit 8 can set the appropriate delay time for achieving both the turn-off loss reduction and the surge voltage suppression depending on the operating condition of the power converter. In this way, according to the gate drive circuit of the embodiment, during the turning-off operation of the switching device 1, the timing of stopping the operation of the off-mode fast drive circuit 5 can be adjusted depending on the operating condition of the power converter to achieve both the turn-off loss reduction and the surge voltage suppression in any operating condition.

In other words, according to the embodiment, a gate drive circuit and a power converter that provide for suppression of a surge voltage in a switching device and a reduction in switching loss can be provided.

A gate drive circuit and a power converter of a third embodiment will now be described in detail with reference to the drawings. In the description below, like components as in the first embodiment and the second embodiment will be given like reference characters and the description will not be repeated.

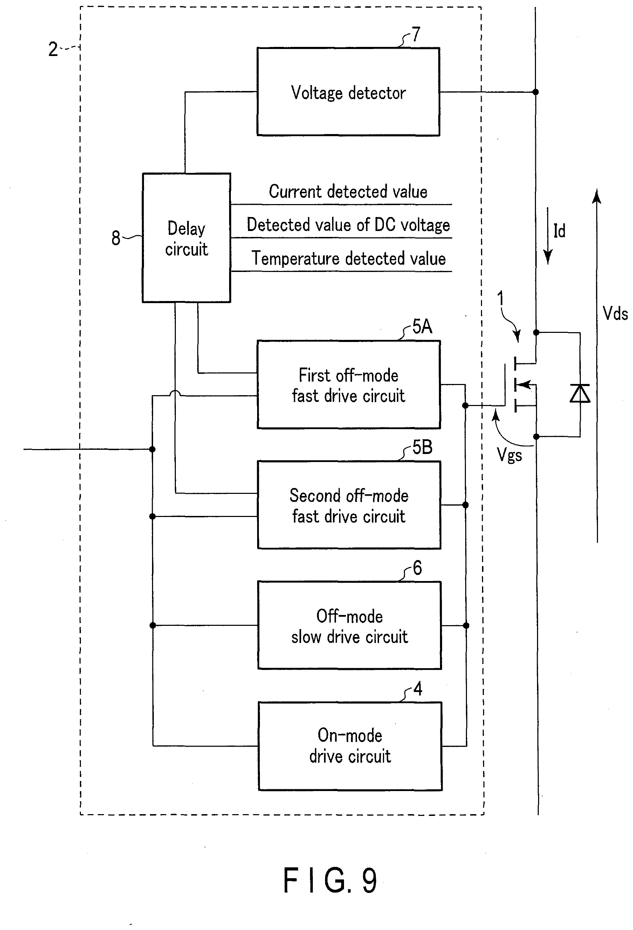

FIG. 9 schematically illustrates an example configuration of a gate drive circuit of a third embodiment.

A gate drive circuit 2 of the embodiment is different from the gate drive circuits of the first embodiment and the second embodiment described above in that the gate drive circuit comprises a first off-mode fast drive circuit 5A and a second off-mode fast drive circuit 5B instead of the off-mode fast drive circuit 5, and the delay circuit 8 outputs signals for switching between operating states (operating or stopped) to each of the first off-mode fast drive circuit 5A and the second off-mode fast drive circuit 5B.

The delay circuit 8 obtains the operating condition of the power converter and outputs a signal for switching between the operating states for the first off-mode fast drive circuit 5A and the second off-mode fast drive circuit 5B depending on the operating condition of the power converter. In the description below, a truth value of a signal input from the delay circuit 8 to the first off-mode fast drive circuit 5A is referred to as a first truth value and a truth value of a signal input from the delay circuit 8 to the second off-mode fast drive circuit 5B is referred to as a second truth value. The signals input from the delay circuit 8 to the first off-mode fast drive circuit 5A and the second off-mode fast drive circuit 5B are not limited to binary signals but the truth value is "0" when the value of the signal is equal to or below a predetermined threshold value, and the truth value is "1" when the predetermined threshold value is exceeded.

For example, the delay circuit 8 sets the first off-mode fast drive circuit 5A to the operating state (first output truth value = 0) when the detected value of the drain current Id is less than the current threshold value and the value of a delayed drain-source voltage Vds is equal to or below a predetermined threshold value, and sets the first off-mode fast drive circuit 5A to the stopped state (first output truth value = 1) when the detected value of the drain current Id is equal to or above the current threshold value and the value of the delayed drain-source voltage Vds exceeds the predetermined threshold value.

For example, the delay circuit 8 sets the second off-mode fast drive circuit to the operating state (second output truth value = 0) when the detected value of the drain current Id is equal to or above the current threshold value and the value of a delayed drain-source voltage Vds is equal to or below a predetermined threshold value, and sets the second off-mode fast drive circuit 5B into the stopped state (second output truth value = 1) when the detected value of the drain current Id is less than the current threshold value and the value of the delayed drain-source voltage Vds exceeds the predetermined threshold value.

The delay circuit 8 can obtain the value indicative of the operating condition of the power converter (for example, a value of the cut-off current (the drain current Id at the start of turning-off operation), a value of the DC voltage Vcc, and a temperature value of the switching device 1), and adjust each of delay time of a signal to the first off-mode fast drive circuit 5A and delay time of a signal to the second off-mode fast drive circuit 5B depending on the obtained value.

The first off-mode fast drive circuit 5A and the second off-mode fast drive circuit 5B are different in speed (gate resistance values) when the switching device 1 is being turned off.

The first off-mode fast drive circuit 5A includes a third off-state resistor (not illustrated) electrically connected to the gate terminal of the switching device 1. To the first off-mode fast drive circuit 5A, the gate signal is input from the upper-level controller and a signal for switching between operating states (operating or stopped) output from the delay circuit 8 is input.

The first off-mode fast drive circuit 5A is configured to stop applying a control signal (gate voltage) for turning off the switching device 1 through the third off-state resistor to the gate terminal when the first truth value of the signal input from the delay circuit 8 is "1" (for example, the detected value of the drain current Id is less than the current threshold value and a delayed drain-source voltage Vds exceeds a predetermined threshold value).

Further, the first off-mode fast drive circuit 5A is configured to apply a control signal (gate voltage) for turning off the switching device 1 through the third off-mode resistor to the gate terminal when the first truth value of the signal input from the delay circuit 8 is "0" (for example, for the duration in which the detected value of the drain current Id is equal to or above the current threshold value and when a delayed drain-source voltage Vds is equal to or below a predetermined threshold value).

The second off-mode fast drive circuit 5B comprises a fourth off-mode resistor (not illustrated) electrically connected to the gate terminal of the switching device 1. To the second off-mode fast drive circuit 5B, the gate signal is input from the upper-level controller, and a signal for switching between operating states (operating or stopped) is input from the delay circuit 8.

The second off-mode fast drive circuit 5B is configured to stop applying a control signal (gate voltage) for turning off the switching device 1 through the fourth off-mode resistor to the gate terminal when the second truth value of the signal input from the delay circuit 8 is "1" (for example, the detected value of the drain current Id is equal to or above the current threshold value and the delayed drain-source voltage Vds exceeds a predetermined threshold value).

Further, the second off-mode fast drive circuit 5B is configured to apply a control signal (gate voltage) for turning off the switching device 1 through the fourth off-mode resistor to the gate terminal when the second truth value of the signal input from the delay circuit 8 is "0" (for example, for the duration in which the detected value of the drain current Id is less than the current threshold value, and when the delayed drain-source voltage Vds is equal to or below a predetermined threshold value).

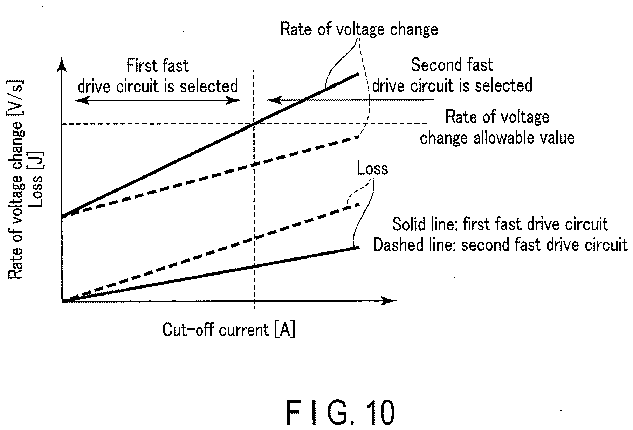

FIG. 10 shows an example of operation of switching between operating states of a first off-mode fast drive circuit and a second off-mode fast drive circuit by a delay circuit in a third embodiment.

In the embodiment, the resistance value of the third off-mode resistor is smaller than the resistance value of the fourth off-mode resistor, and the first off-mode fast drive circuit 5A can turn off the switching device 1 faster than the second off-mode fast drive circuit 5B.

There is a trade-off relationship between the rate of voltage change of the drain-source voltage Vds and loss when the switching device 1 is being turned off. The rate of voltage change of the drain-source voltage Vds when the switching device 1 is being turned off by the first off-mode fast drive circuit 5A is larger than the rate of voltage change of the drain-source voltage Vds when the switching device 1 is being turned off by the second off-mode fast drive circuit 5B. On the other hand, a loss occurring when the switching device 1 is being turned off by the first off-mode fast drive circuit 5A is smaller than the loss occurring when the switching device 1 is being turned off by the second off-mode fast drive circuit 5B.

The gate drive circuit 1, for example, uses a detected current (drain current Id) value at which the rate of voltage change of the drain-source voltage Vds reaches an allowable value when the switching device 1 is being turned off by the first off-mode fast drive circuit 5A as a current threshold value of the cut-off current. The gate drive circuit 2 of the embodiment is controlled such that the first off-mode fast drive circuit 5A is operated when the value of the cut-off current is less than the current threshold value and the second off-mode fast drive circuit 5B is operated when the detected current value is equal to or above the current threshold value according to a signal supplied from the delay circuit 8.

As described above, by switching between the first off-mode fast drive circuit 5A and the second off-mode fast drive circuit 5B, which are different in a turning-off speed, depending on the value of the cut-off current, it is possible to suppress the surge voltage when the switching device 1 is being turned off and reduce the loss that occurs during turning off.

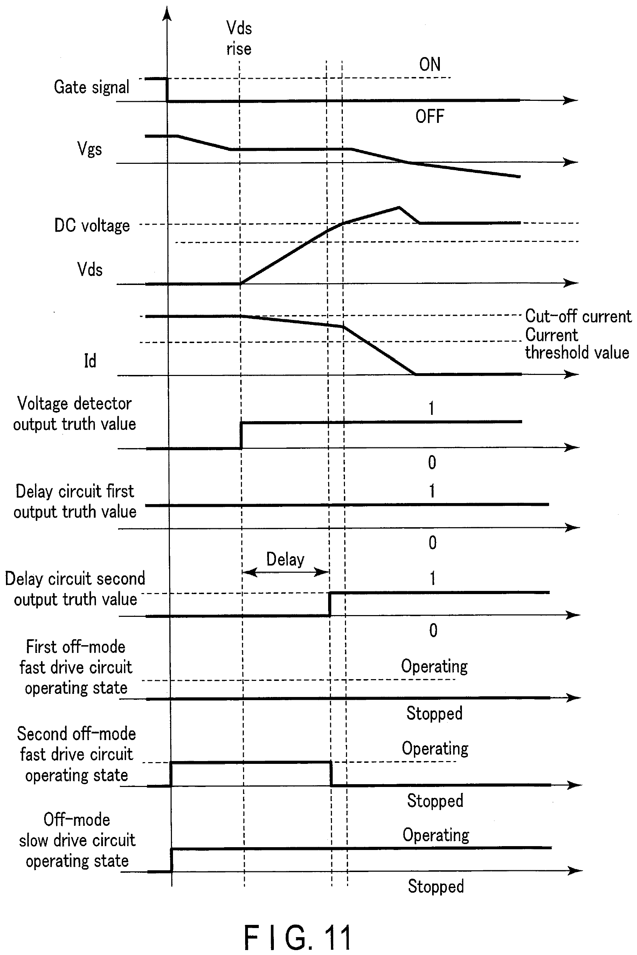

FIG. 11 is a timing chart showing an example of operation of the gate drive circuit when the switching device is being turned off in the third embodiment.

Here, examples of the gate signal input to the gate drive circuit 2, the drain-source voltage Vds and a gate-source voltage Vgs of the switching device 1, a drain current Id, a truth value of the voltage detector 7, a first truth value and a second truth value of signals output from the delay circuit 8, the operating state (operating or stopped) of the first off-mode fast drive circuit 5A, the operating state (operating or stopped) of the second off-mode fast drive circuit 5B, and the operating state (operating or stopped) of the off-mode slow drive circuit 6 are indicated in a timing chart.

In this example, at a timing of the gate signal being turned off, the cut-off current is equal to or above the current threshold value, the first truth value of the signal supplied from the delay circuit 8 to the first off-mode fast drive circuit 5A is "1", and the first off-mode fast drive circuit 5A is stopped. Accordingly, in this example, the first off-mode fast drive circuit 5A does not perform turning-off operation of the switching device 1.

For example, as described above, at a timing of the gate signal being turned off, determination is made as to which driving circuit is used to turn off the switching device 1 by comparing the current threshold value with the cut-off current, the result of the comparison is thereafter held, and turning off of the switching device 1 is completed.

Further, at a timing of the gate signal being turned off, the cut-off current is equal to or above the current threshold value and the drain-source voltage Vds is an on-time voltage value (predetermined threshold value or less), the second truth value of the signal supplied to the second off-mode fast drive circuit 5B is "0", and the second off-mode fast drive circuit 5B is in the operating state. Thereafter, when the drain-source voltage Vds rises according to a control signal supplied from the second off-mode fast drive circuit 5B and the off-mode slow drive circuit 6, the second truth value is turned to "1" after a predetermined time (delay time) and the second off-mode fast drive circuit 5B is stopped.

Thereafter, turning off of the switching device 1 is completed by a control signal supplied from the off-mode slow drive circuit 6.

As described above, by switching the operation between the driving circuits, which are different in a speed of turning off the switching device 1, depending on the value of the cut-off current, it is possible to achieve both the turn-off loss reduction and the surge voltage suppression.

In other words, according to the embodiment, a gate drive circuit and a power converter that provide for suppression of a surge voltage in a switching device and a reduction in switching loss can be provided.

Although in the embodiment, the gate drive circuit 2 comprising two off-mode fast drive circuits has been described, the gate drive circuit 2 may comprise 3 or more off-mode fast drive circuits. In this case, a similar effect to the gate drive circuit 2 described above can be produced by setting a plurality of current threshold values for the cut-off current of the switching device 1 and switching between operating states of 3 or more off-mode fast drive circuits.

A gate drive circuit and a power converter of a fourth embodiment will now be described in detail with reference to the drawings. In the description below, like components as in the first to third embodiments will be given like reference characters and the description will not be repeated.

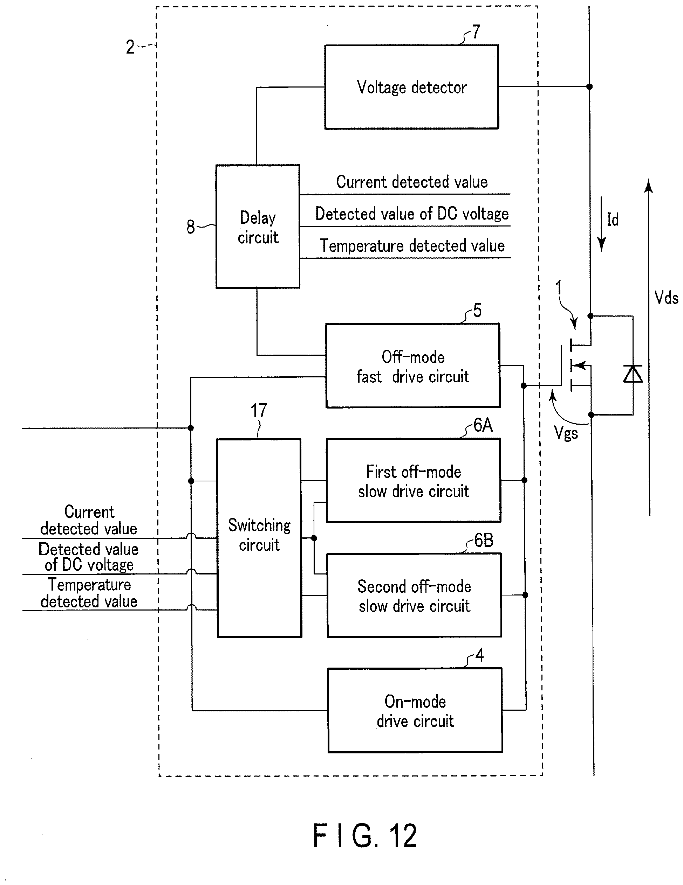

FIG. 12 schematically illustrates an example configuration of a gate drive circuit of a fourth embodiment.

A gate drive circuit 2 of the embodiment is different from that of the second embodiment described above in that the gate drive circuit comprises a first off-mode slow drive circuit 6A, a second off-mode slow drive circuit 6B, and a switching circuit 17 instead of the off-mode slow drive circuit 6.

The first off-mode slow drive circuit 6A receives the gate signal and a signal for switching between operating states (operating or stopped) from the switching circuit 17. The first off-mode slow drive circuit 6A performs or stops operation of turning off the switching device 1 depending on the value of a signal from the switching circuit 17. The first off-mode slow drive circuit 6A includes a fifth off-mode resistor (not illustrated) connected to the gate terminal of the switching device 1, and applies a control signal to the gate terminal of the switching device 1 through the fifth off-state resistor.

The second off-mode slow drive circuit 6B receives the gate signal and a signal for switching between operating states (operating or stopped) from the switching circuit 17. The second off-mode slow drive circuit 6B performs or stops operation of turning off the switching device 1 depending on the value of a signal from the switching circuit 17. The second off-mode slow drive circuit 6B includes a sixth off-mode resistor (not illustrated) connected to the gate terminal of the switching device 1, and applies a control signal to the gate terminal of the switching device 1 through the sixth off-mode resistor.

The first off-mode slow drive circuit 6A and the second off-mode slow drive circuit 6B are different in a speed of turning off the switching device 1. In the embodiment, the first off-mode slow drive circuit 6A can turn off the switching device 1 faster than the second off-mode slow drive circuit 6B. In other words, the resistance value (gate resistance value) of the fifth off-mode resistor of the first off-mode slow drive circuit 6A is smaller than the resistance value (gate resistance value) of the sixth off-mode resistor of the second off-mode slow drive circuit 6B.

Depending on the operating condition of the power converter, the switching circuit 17 outputs a signal for switching between operating states to the first off-mode slow drive circuit 6A and the second off-mode slow drive circuit 6B.

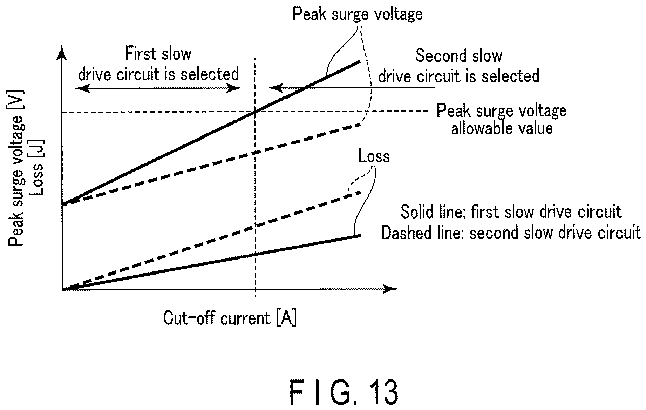

FIG. 13 shows an example of operation of switching between operating states of first off-mode slow drive circuit and second off-mode slow drive circuit by a switching circuit in the fourth embodiment.

There is a trade-off relationship between the peak surge voltage generated and a loss when the switching device 1 is being turned off. The peak surge voltage generated when the switching device 1 is turned off by the first off-mode slow drive circuit 6A becomes larger than the peak surge voltage generated when the switching device 1 is turned off by the second off-mode slow drive circuit 6B. On the other hand, a loss occurring when the switching device 1 is being turned off by the first off-mode slow drive circuit 6A becomes smaller than the loss occurring when the switching device 1 is being turned off by the second off-mode slow drive circuit 6B.

A current threshold value is set using the cut-off current (drain current Id) value at which the peak surge voltage occurred when the switching device 1 is being turned off by the first off-mode slow drive circuit 6A reaches an allowable value. For example, the cut-off current is set as the current threshold value. In this case, the switching circuit 17 of the gate drive circuit 2 is controlled to activate the fist off-mode slow drive circuit 6A, when the value of the cut-off current is less than the current threshold value. On the other hand, the switching circuit 17 is controlled to activate the second off-mode slow drive circuit 6B, when the value of the cut-off current is equal to or above the current threshold value.

As described above, by switching between the first off-mode slow drive circuit 6A and the second off-mode slow drive circuit 6B, which are different in a turning-off speed, depending on the value of the cut-off current, it is possible to suppress the surge voltage when the switching device 1 is being turned off and reduce the loss that occurs during turning off.

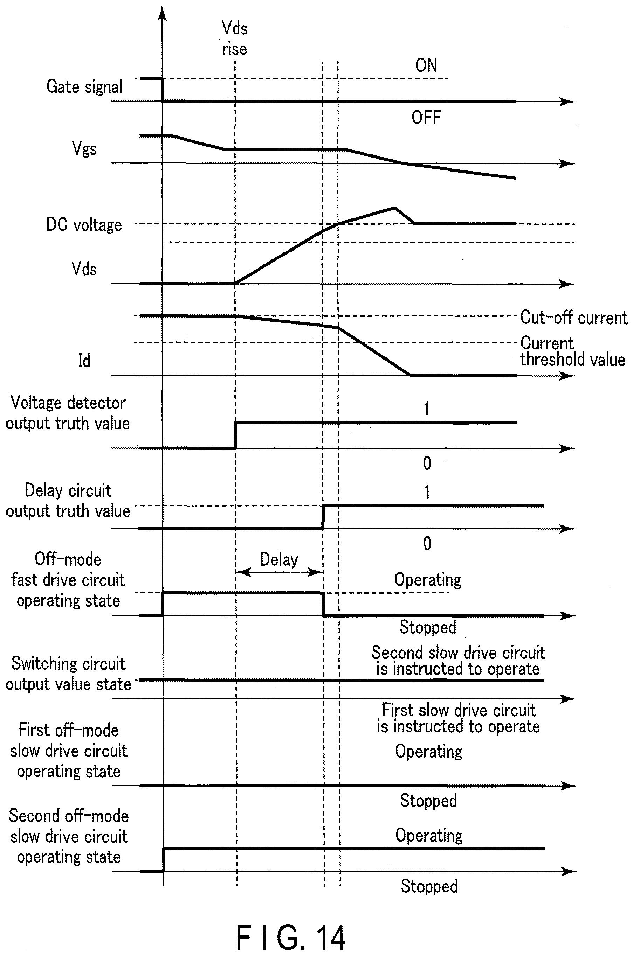

FIG. 14 is a timing chart for describing an example of operation of the gate drive circuit when the switching device is being turned off in the fourth embodiment.

Here, examples of the gate signal input to the gate drive circuit 2, the drain-source voltage Vds and a gate-source voltage Vgs of the switching device 1, a drain current Id, a truth value output from the voltage detector 7, a truth value of signals output from the delay circuit 8, the operating state (operating or stopped) of the off-mode fast drive circuit 5, an output value state of the switching circuit 17, the operating state (operating or stopped) of the first off-mode slow drive circuit 6A, and the operating state (operating or stopped) of the second off-mode slow drive circuit 6A are indicated in a timing chart.

In this example, at a timing of the gate signal being turned off, the cut-off current is equal to or above the current threshold value, and the output value of the switching circuit 17 assumes a value at which the first off-mode slow drive circuit 6A is stopped and the second off-mode slow drive circuit 6B is operated. Accordingly, in this example, the first off-mode slow drive circuit 6A does not perform turning-off operation of the switching device 1.

For example, as described above, at a timing of the gate signal being turned off, determination is made as to which driving circuit is used to turn off the switching device 1 by comparing the current threshold value with the cut-off current, the result of the comparison is thereafter held, and turning off of the switching device 1 is completed.

After the off-mode fast drive circuit 5 is stopped by an output signal of the delay circuit 8, turning off of the switching device 1 is completed by a control signal supplied from the second off-mode slow drive circuit 6B.

As described above, by switching the operation between the driving circuits, which are different in a speed of turning off the switching device 1, depending on the value of the cut-off current, it is possible to achieve both the turn-off loss reduction and the surge voltage suppression.

In other words, according to the embodiment, a gate drive circuit and a power converter that provide for suppression of a surge voltage in a switching device and a reduction in switching loss can be provided.

Although in the embodiment, the gate drive circuit 2 comprising two off-mode slow drive circuit has been described, the gate drive circuit 2 may comprise 3 or more off-mode slow drive circuit. In this case, a similar effect to the gate drive circuit 2 described above can be produced by setting a plurality of current threshold values for the cut-off current of the switching device 1 and switching between operating states of 3 or more off-mode slow drive circuits.

A gate drive circuit and a power converter of a fifth embodiment will now be described in detail with reference to the drawings. In the description below, like components as in the first to fourth embodiments will be given like reference characters and the description will not be repeated.

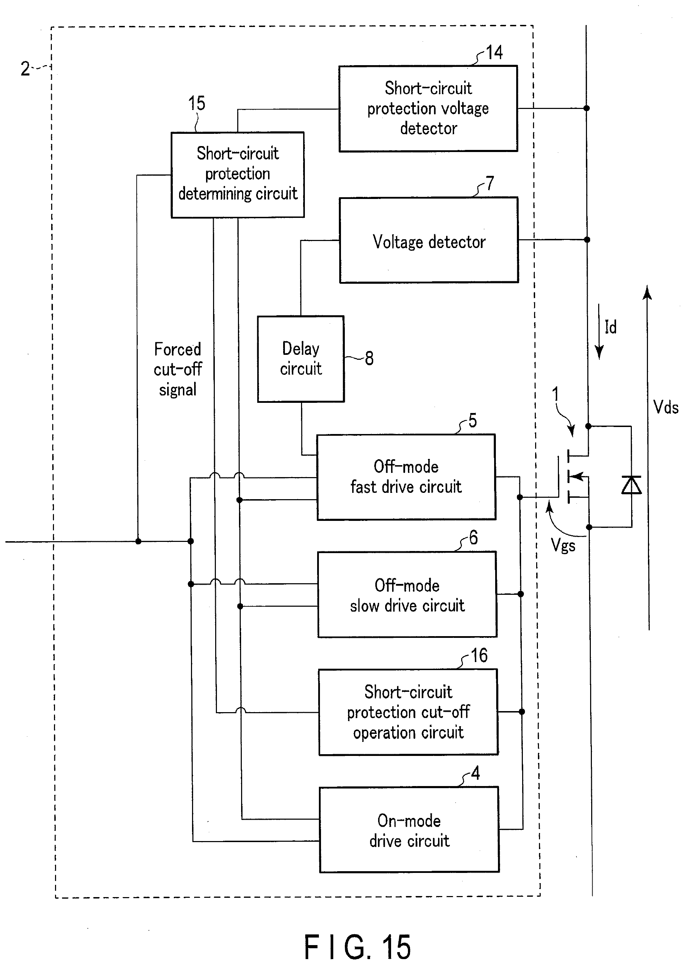

FIG. 15 schematically illustrates an example configuration of a gate driver circuit of a fifth embodiment.

A gate drive circuit 2 of the embodiment is different from that of the first embodiment described above in that the gate drive circuit comprises a short-circuit protection voltage detector (second voltage detector) 14, a short-circuit protection determining circuit (determining circuit) 15, and a short-circuit protection cut-off operation circuit 16.

The short-circuit protection voltage detector 14 detects the value of the drain-source voltage Vds of the switching device 1 and outputs the detected value to the short-circuit protection determining circuit 15.

The short-circuit protection determining circuit 15 determines whether there is a short-circuit in the switching device 1 based on the gate signal and the value of the drain-source voltage Vds detected by the short-circuit protection voltage detector 14. For example, the short-circuit protection determining circuit 15 determines that there is a short-circuit in the switching device 1 when the drain-source voltage Vds of the switching device 1 does not fall even through the gate signal is at an "on" level. Upon determining that there is a short-circuit in the switching device 1, the short-circuit protection determining circuit 15 stops the off-mode fast drive circuit 5, the off-mode slow drive circuit 6, and the on-mode drive circuit 4, and causes the short-circuit protection cut-off operation circuit 16 to forcedly cut off the switching device 1.

The short-circuit protection cut-off operation circuit 16 cuts off the switching device 1 according to a cut off signal from the short-circuit protection determining circuit 15. In the embodiment, the short-circuit protection cut-off operation circuit 16 applies a voltage for turning off the switching device 1 to the gate terminal upon receipt of the cut off signal.

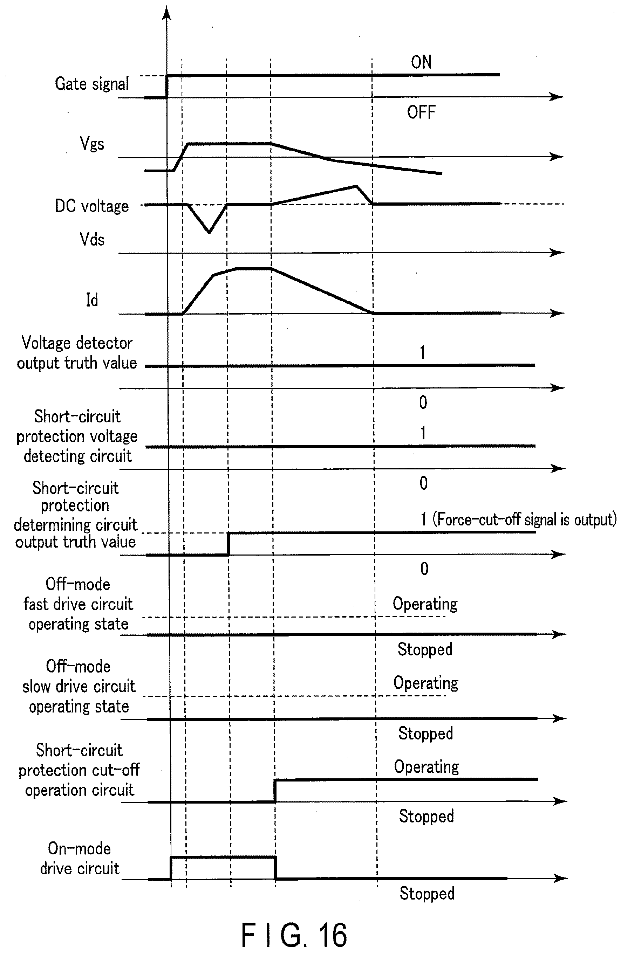

FIG. 16 is a timing chart for describing an example of operation of the gate drive circuit when the switching device is being turned on in the fifth embodiment.

When the gate signal is switched from "off" to "on", the on-mode drive circuit 4 goes into an operating state, and a control signal (gate voltage) is applied from the on-mode drive circuit 4 to the gate terminal of the switching device 1.

The short-circuit protection voltage detecting circuit 14 detects the value of the drain-source voltage Vds of the switching device 1, and supplies the detected value to the short-circuit protection determining circuit 15.

The short-circuit protection determining circuit 15 determines whether there is a short-circuit in the switching device 1 according to the value of the drain-source voltage Vds supplied from the short-circuit protection voltage detector 14 and the value of the gate signal. In the example illustrated in FIG. 16, while the gate signal is turned on, the drain-source voltage Vds does not fall down to a normal on-time value of the switching device 1. In such a case, the short-circuit protection determining circuit 15 determines that there is a short-circuit in the switching device 1, for example, when the drain-source voltage exceeds a predetermined threshold value a predetermined time after the gate signal has been turned on.

Upon determining that there is a short-circuit in the switching device 1, the short-circuit protection determining circuit 15 stops operation of the off-mode fast drive circuit 5, the off-mode slow drive circuit 6, and the on-mode drive circuit 4, and outputs a force-cut-off signal to the short-circuit protection cut-off operation circuit 16.

Upon receipt of the force-cut-off signal from the short-circuit protection determining circuit 15, the short-circuit protection cut-off operation circuit 16 turns off the switching device 1. The short-circuit protection cut-off operation circuit 16 can turn off the switching device 1 slower than the off-mode slow drive circuit 6.

Note that since cutting off of the switching device 1 for short-circuit protection is an operation of cutting off a large current in a short circuit, low-speed cutting off is required for suppressing a surge voltage. Accordingly, in the gate drive circuit 2 of the embodiment, it is possible to suppress a surge voltage during short-circuit protection cutting off, by keeping the off-mode fast drive circuit 5 and the off-mode slow drive circuit 6 in the stopped state and performing cutting-off operation only by the short-circuit protection cut-off operation circuit 16 during short-circuit cutting off.

As described above, according to the gate drive circuit 2 and the power converter of the embodiment, it is also possible to suppress a surge voltage when there is a short circuit in the switching device 1 and short-circuit protection cutting off is performed.

In other words, according to the embodiment, a gate drive circuit and a power converter that provide for suppression of a surge voltage in a switching device and a reduction in switching loss can be provided.

A gate drive circuit and a power converter of a sixth embodiment will now be described in detail with reference to the drawings. In the description below, like components as in the first to fifth embodiments will be given like reference characters and the description will not be repeated.

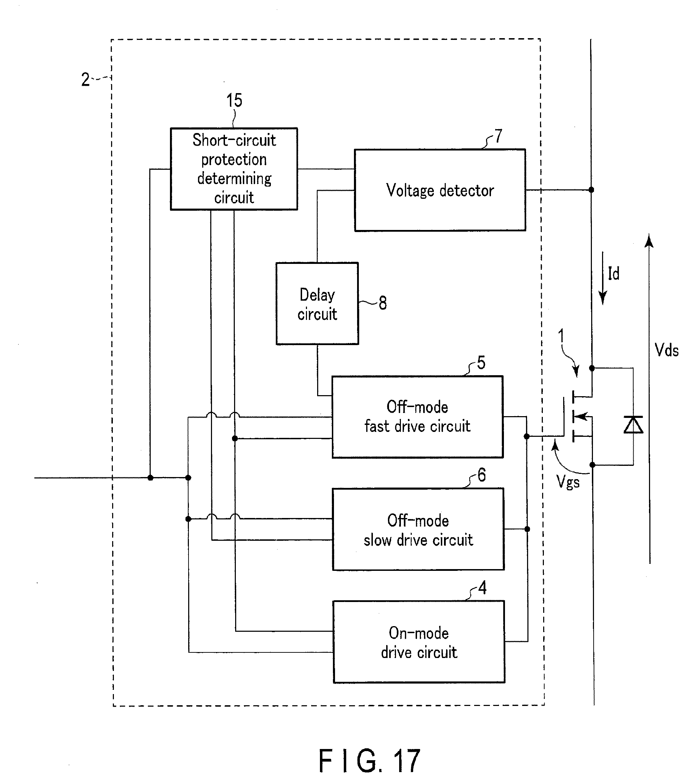

FIG. 17 schematically illustrates an example configuration of a gate drive circuit of a sixth embodiment.

A gate drive circuit 2 of the embodiment is different from that of the first embodiment described above in that the gate drive circuit comprises a short-circuit protection determining circuit 15.

The voltage detector 7 detects the value of the drain-source voltage Vds of the switching device 1, and outputs the detected value to the delay circuit 8 and the short-circuit protection determining circuit 15. In other words, in the gate drive circuit 2 of the embodiment, the voltage detector 7 also includes a function of the short-circuit protection voltage detector 14 in the fifth embodiment.

The short-circuit protection determining circuit 15 determines whether there is a short-circuit in the switching device 1 based on the gate signal and the value of the drain-source voltage Vds detected by the voltage detector 7. For example, the short-circuit protection determining circuit 15 determines that there is a short-circuit in the switching device 1 when the drain-source voltage Vds of the switching device 1 does not fall even through the gate signal is at an "on" level. Upon determining that there is a short-circuit in the switching device 1, the short-circuit protection determining circuit 15 stops the off-mode fast drive circuit 5 and the on-mode drive circuit 4, and causes the off-mode slow drive circuit 6 to forcedly cut off the switching device 1.

In other words, in the gate drive circuit 2 of the embodiment, when it is determined that there is a short circuit in the switching device 1, the off-mode slow drive circuit 6 functions as the short-circuit protection cut-off operation circuit 16 in the fifth embodiment.

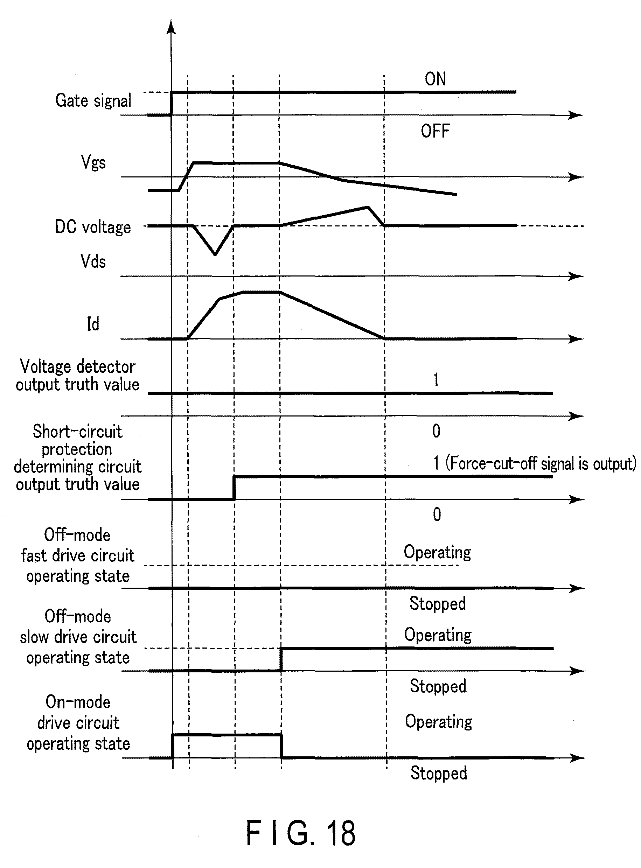

FIG. 18 is a timing chart for describing an example of operation of the gate drive circuit when the switching device is being turned on in the sixth embodiment.

When the gate signal is switched from "off" to "on", the on-mode drive circuit 4 goes into an operating state, and a control signal (gate voltage) is applied from the on-mode drive circuit 4 to the gate terminal of the switching device 1.

The voltage detector 7 detects the value of the drain-source voltage Vds of the switching device 1, and supplies the detected value to the short-circuit protection determining circuit 15.

The short-circuit protection determining circuit 15 determines whether there is a short-circuit in the switching device 1 according to the value of the drain-source voltage Vds supplied from the voltage detector 7 and the value of the gate signal. In the example illustrated in FIG. 18, while the gate signal is turned on and the drain-source voltage Vds temporarily falls, thereafter the drain-source voltage Vds rises again and becomes a DC voltage. In such a case, the short-circuit protection determining circuit 15 determines that there is a short-circuit in the switching device 1, for example, when the drain-source voltage exceeds a predetermined threshold value a predetermined time after the gate signal has been turned on.

Upon determining that there is a short-circuit in the switching device 1, the short-circuit protection determining circuit 15 stops operation of the off-mode fast drive circuit 5 and the on-mode drive circuit 4, and outputs a force-cut-off signal to the off-mode slow drive circuit 6.

Upon receipt of the force-cut-off signal from the short-circuit protection determining circuit 15, the off-mode slow drive circuit 6 turns off the switching device 1. At this time, the off-mode slow drive circuit 6 may be configured to turn off the switching device 1 slower than when the switching device 1 is normally turned off.

In the gate drive circuit 2 of the embodiment, the off-mode slow drive circuit 6 is provided with a function as the short-circuit protection cut-off operation circuit 16 and the off-mode slow drive circuit 6 is caused to perform the force-cut-off operation during short-circuit cutting off, so that it is possible to suppress a surge voltage during short-circuit protection cutting off although the short-circuit protection cut-off operation circuit 16 is eliminated. Further, the voltage detector 7 is provided with a function as the short-circuit protection voltage detector, so that the short-circuit protection voltage detector can be eliminated. According to the gate drive circuit 2 of the embodiment, therefore, a smaller number of components than the gate driver circuit of the fifth embodiment can be used for cost reduction.

In other words, according to the embodiment, a gate drive circuit and a power converter that provide for suppression of a surge voltage in a switching device and a reduction in switching loss can be provided.

While certain embodiments have been described, these embodiments have been presented by way of example only, and are not intended to limit the scope of the inventions. Indeed, the novel methods and systems described herein may be embodied in a variety of other forms. The accompanying claims are intended to cover such forms or modifications as would fall within the scope of the invention as defined in the accompanying claims.

**Claims**

1.  A gate drive circuit comprising:

    a first voltage detector (7) configured to detect a first voltage between a source terminal and a drain terminal of a switching device (1) and configured to output voltage information based on the detected first voltage;
    a delay circuit (8) that is configured to output, with a delay for a predetermined time, the voltage information from the first voltage detector;
    a first off-mode drive circuit (5, 5A, 5B) configured to apply a control signal to a control terminal of the switching device (1) for turning off the switching device (1); and
    a second off-mode drive circuit (6, 6A, 6B) configured to apply a control signal to the control terminal of the switching device (1) for turning off the switching device (1),
    wherein
    both of the first off-mode drive circuit (5, 5A, 5B) and the second off-mode drive circuit (6, 6A, 6B) are configured to apply the control signal to the control terminal of the switching device (1) in response to a gate signal switching from on to off, and thereafter the first off-mode drive circuit (5, 5A, 5B), configured to turn off the switching device faster than the second off-driving circuit (6, 6A, 6B), is configured to stop applying the control signal to the control terminal of the switching device (1) for turning off the switching device (1) when the voltage information output with the delay by the delay circuit (8) indicates that the first voltage exceeds a predetermined threshold value;
    **characterised in that** the delay used by the delay circuit is smaller than a value obtained by dividing the first voltage at completion of turning off of the switching device by a maximum value of a rate of change of the first voltage when the switching device is being turned off.

2.  The gate drive circuit according to claim 1, wherein the delay circuit obtains a cut-off current, indicating a current detected value of a drain current at a start of turning-off operation of the switching device, and adjusts time for delay according to the obtained cut-off current.

3.  The gate drive circuit according to claim 1, further comprising:

    a second voltage detector that detects a second voltage between the source terminal and the drain terminal of the switching device;
    a determining circuit that determines whether there is a short-circuit in the switching device based on the second voltage detected by the second voltage detector and a value of a control signal from an upper-level controller for controlling operation of the switching device, and when it is determined that there is a short-circuit in the switching device, stops the first off-mode drive circuit and the second off-mode drive circuit and outputs a force-cut-off signal; and
    a short-circuit protection cut-off operation circuit that cuts off the switching device upon receipt of the force-cut-off signal.

4.  The gate drive circuit according to claim 1, further comprising a determining circuit that determines whether there is a short-circuit in the switching device based on the first voltage detected by the first voltage detector and a value of a control signal from an upper-level controller for controlling operation of the switching device, and when it is determined that there is a short-circuit in the switching device, stops the first off-mode drive circuit and outputs a force-cut-off signal to the second off-mode drive circuit,
    wherein the second off-mode drive circuit cuts off the switching device upon receipt of the force-cut-off signal.

5.  A power converter comprising:

    a plurality of switching devices; and
    a plurality of the gate drive circuits as claimed in any one of claims 1 to 4.

**Patentansprüche**

1.  Gate-Ansteuerschaltung, umfassend:

    einen ersten Spannungsdetektor (7) konfiguriert zum Detektieren einer ersten Spannung zwischen einem Source-Anschluss und einem Drain-Anschluss einer Schaltvorrichtung (1) und konfiguriert zum Ausgeben von Spannungsinformation auf Grundlage der detektierten ersten Spannung;

eine Verzögerungsschaltung (8) konfiguriert zum Ausgeben, mit einer Verzögerung für eine vorbestimmte Zeit, der Spannungsinformation von dem ersten Spannungsdetektor;

eine erste AUS-Modus-Ansteuerschaltung (5, 5A, 5B) konfiguriert zum Anlegen eines Steuersignals an einen Steueranschluss der Schaltvorrichtung (1) zum Ausschalten der Schaltvorrichtung (1); und

eine zweite AUS-Modus-Ansteuerschaltung (6, 6A, 6B) konfiguriert zum Anlegen eines Steuersignals an den Steueranschluss der Schaltvorrichtung (1) zum Ausschalten der Schaltvorrichtung (1),

wobei

sowohl die erste AUS-Modus-Ansteuerschaltung (5, 5A, 5B) als auch die zweite AUS-Modus-Ansteuerschaltung (6, 6A, 6B) konfiguriert sind zum Anlegen des Steuersignals an den Steueranschluss der Steuervorrichtung (1) in Reaktion auf ein Gate-Signal, das von EIN zu AUS schaltet, und danach die erste AUS-Modus-Ansteuerschaltung (5, 5A, 5B), die konfiguriert ist, die Steuervorrichtung schneller auszuschalten als die zweite AUS-Modus-Ansteuerschaltung (6, 6A, 6B), konfiguriert zum Beenden des Anlegens des Steuersignals an die Steuerklemme der Steuervorrichtung (1) zum Ausschalten der Steuervorrichtung (1), wenn die von der Verzögerungsschaltung (8) mit Verzögerung ausgegebene Spannungsinformation anzeigt, dass die erste Spannung einen vorbestimmten Schwellenwert überschreitet;

**dadurch gekennzeichnet, dass** die von der Verzögerungsschaltung verwendete Verzögerung kleiner ist als ein Wert, der durch Dividieren der ersten Spannung bei Abschluss des Ausschaltens der Schaltvorrichtung durch einen Maximalwert einer Änderungsrate der ersten Spannung erhalten wird, wenn die Schaltvorrichtung ausgeschaltet wird.

**2.** Gate-Ansteuerschaltung gemäß Anspruch 1, wobei die Verzögerungsschaltung einen Abschaltstrom erhält, der einen aktuell erfassten Wert eines Drain-Stroms zu Beginn des Ausschaltvorgangs der Schaltvorrichtung angibt, und die Verzögerungszeit gemäß dem erhaltenen Abschaltstrom anpasst.

**3.** Gate-Ansteuerschaltung gemäß Anspruch 1, ferner umfassend:

einen zweiten Spannungsdetektor, der eine zweite Spannung zwischen dem Source-Anschluss und dem Drain-Anschluss der Schaltvorrichtung detektiert;

eine Bestimmungsschaltung, die bestimmt, ob in der Schaltvorrichtung ein Kurzschluss vorliegt, auf Grundlage der durch den zweiten Spannungsdetektor detektierten zweiten Spannung und eines Werts eines Steuersignals von einer übergeordneten Steuerung zum Steuern des Betriebs der Schaltvorrichtung, und die, wenn bestimmt wird, dass in der Schaltvorrichtung ein Kurzschluss vorliegt, die erste AUS-Modus-Ansteuerschaltung und die zweite AUS-Modus-Ansteuerschaltung stoppt und ein Zwangs-Abschaltsignal ausgibt; und

eine Kurzschlussschutz-Abschaltbetrieb-Schaltung, die die Schaltvorrichtung bei Empfang des Zwangs-Abschaltsignals abschaltet.

**4.** Gate-Ansteuerschaltung gemäß Anspruch 1, ferner umfassend:

eine Bestimmungsschaltung, die bestimmt, ob in der Schaltvorrichtung ein Kurzschluss vorliegt, auf Grundlage der durch den ersten Spannungsdetektor detektierten ersten Spannung und eines Werts eines Steuersignals von einer übergeordneten Steuerung zum Steuern des Betriebs der Schaltvorrichtung, und die, wenn bestimmt wird, dass in der Schaltvorrichtung ein Kurzschluss vorliegt, die erste AUS-Modus-Ansteuerschaltung stoppt und ein Zwangs-Abschaltsignal an die zweite AUS-Modus-Ansteuerschaltung ausgibt; und

wobei die zweite AUS-Modus-Ansteuerschaltung die Schaltvorrichtung bei Empfang des Zwangs-Abschaltsignals abschaltet.

**5.** Stromwandler, umfassend:

eine Vielzahl von Schaltvorrichtungen; und

eine Vielzahl von Gate-Ansteuerschaltungen, wie in einem der Ansprüche 1 bis 4 beansprucht.

**Revendications**

**1.** Circuit de commande de grille comprenant :

un premier détecteur de tension (7) configuré pour détecter une première tension entre une borne source et une borne drain d'un dispositif de commutation (1) et configuré pour délivrer en sortie des informations de tension sur la base de la première tension détectée ;

un circuit à retard (8) qui est configuré pour délivrer en sortie, avec un retard pendant un temps prédéterminé, les informations de tension provenant du premier détecteur de tension ;

un premier circuit de commande en mode arrêt (5, 5A, 5B) configuré pour appliquer un signal de commande à une borne de commande du dispositif de commutation (1) pour désactiver le dispositif de commutation (1) ; et

un second circuit de commande en mode arrêt (6, 6A, 6B) configuré pour appliquer un signal de commande à la borne de commande du dispositif de commutation (1) pour désactiver le dispositif de commutation (1),

dans lequel le premier circuit de commande en mode arrêt (5, 5A, 5B) et le second circuit de commande en mode arrêt (6, 6A, 6B) sont tous deux configurés pour appliquer le signal de commande à la borne de commande du dispositif de commutation (1) en réponse à une commutation du signal de grille de marche à arrêt, et ensuite le premier circuit de commande en mode arrêt (5, 5A, 5B), configuré pour désactiver le dispositif de commutation plus rapidement que le second circuit de commande en mode arrêt (6, 6A, 6B), est configuré pour arrêter l'application du signal de commande à la borne de commande du dispositif de commutation (1) pour désactiver le dispositif de commutation (1) lorsque les informations de tension délivrées en sortie avec le retard par le circuit à retard (8) indiquent que la première tension dépasse une valeur de seuil prédéterminée ; **caractérisé en ce que** le retard utilisé par le circuit à retard est plus petit qu'une valeur obtenue en divisant la première tension à l'achèvement de la désactivation du dispositif de commutation par une valeur maximale d'un taux de changement de la première tension lorsque le dispositif de commutation est désactivé.

2.  Circuit de commande de grille selon la revendication 1, dans lequel le circuit à retard obtient un courant de coupure, indiquant une valeur détectée de courant d'un courant de drain à un démarrage d'une opération de désactivation du dispositif de commutation, et ajuste le temps de retard selon le courant de coupure obtenu.

3.  Circuit de commande de grille selon la revendication 1, comprenant en outre :

    un second détecteur de tension qui détecte une seconde tension entre la borne source et la borne drain du dispositif de commutation ;

    un circuit de détermination qui détermine s'il existe un court-circuit dans le dispositif de commutation sur la base de la seconde tension détectée par le second détecteur de tension et d'une valeur d'un signal de commande provenant d'un dispositif de commande de niveau supérieur pour commander le fonctionnement du dispositif de commutation, et lorsqu'il est déterminé qu'il existe un court-circuit dans le dispositif de commutation, arrête le premier circuit de commande en mode arrêt et le second circuit de commande en mode arrêt et délivre en sortie un signal de coupure de force ; et

    un circuit d'opération de coupure de protection de court-circuit qui coupe le dispositif de commutation lors de la réception du signal de coupure de force.

4.  Circuit de commande de grille selon la revendication 1, comprenant en outre un circuit de détermination qui détermine s'il existe un court-circuit dans le dispositif de commutation sur la base de la première tension détectée par le premier détecteur de tension et d'une valeur d'un signal de commande provenant d'un dispositif de commande de niveau supérieur pour commander le fonctionnement du dispositif de commutation, et lorsqu'il est déterminé qu'il existe un court-circuit dans le dispositif de commutation, arrête le premier circuit d'attaque en mode arrêt et délivre en sortie un signal de coupure de force au second circuit d'attaque en mode arrêt,

    dans lequel le second circuit d'attaque en mode arrêt coupe le dispositif de commutation lors de la réception du signal de coupure de force.

5.  Convertisseur de puissance comprenant :

    une pluralité de dispositifs de commutation ; et
    une pluralité des circuits de commande de grille selon l'une quelconque des revendications 1 à 4.

F I G. 1

F I G. 2

F I G. 3

F I G. 4

FIG. 5

F I G. 6

F I G. 7

FIG. 8

FIG. 9

FIG. 10

F I G. 11

24

EP 4 117 182 B1

F I G. 12

Peak surge voltage

First slow
drive circuit is selected

Second slow
drive circuit is selected

Peak surge voltage
allowable value

Loss

Solid line: first slow drive circuit
Dashed line: second slow drive circuit

Peak surge voltage [V]
Loss [J]

Cut-off current [A]

F I G. 13

F I G. 14

F I G. 15

F I G. 16

F I G. 17

F I G. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170093392 A1
- US 2017104479 A1
- US 2021184557 A1
- US 10505529 B1